# EUROPÄISCHE PATENTSCHRIFT

(11) **EP 3 198 519 B1**
(45) Veröffentlichungstag und Bekanntmachung des Hinweises auf die Patenterteilung: **05.12.2018**
(21) Anmeldenummer: 15771021.1
(22) Anmeldetag: 22.09.2015
(51) Int. Cl.: G06K 19/073, H04L 27/14, H03M 1/34, H03M 1/18, G06K 19/07, H04B 1/10, H04B 1/22

(54) **VERFAHREN UND SICHERHEITSMODUL ZUM ANPASSEN EINES REFERENZWERTES ZUM GENERIEREN EINES BITSTROMES**
METHOD AND SECURITY MODULE FOR ADAPTATION OF A REFERENCE VALUE FOR GENERATION OF A BIT STREAM
PROCÉDÉ ET MODULE DE SÉCURITÉ POUR L'ADAPTATION D'UNE VALEUR DE RÉFÉRENCE EN VUE DE LA GÉNÉRATION D'UN TRAIN DE BITS

(30) Priorität: 26.09.2014 DE 102014014449
(43) Veröffentlichungstag der Anmeldung: 02.08.2017
(73) Patentinhaber: Giesecke+Devrient Mobile Security GmbH, 81677 München (DE)
(72) Erfinder: FINKENZELLER, Klaus, 85774 Unterföhring (DE); PFEIFFER, Florian, 85567 Grafing bein München (DE)
(86) Internationale Anmeldenummer: PCT/EP2015/001883
(87) Internationale Veröffentlichungsnummer: WO 2016/045789

(56) Entgegenhaltungen:
- JP-A- 2006 050 311
- US-A- 5 424 738
- US-A1- 2013 321 190

## Beschreibung

Aus der US 5 424 738 A ist ein Verfahren bekannt, welches den Offset eines A/D-Konverters automatisch kompensiert. Dabei wird ein Bitstrom aus einem demodulierten Eingangssignal basierend auf einem ersten Referenzwert ausgegeben.

Die vorliegende Erfindung betrifft ein Verfahren und eine Schaltung gemäß dem Oberbegriff der unabhängigen Ansprüche.
Insbesondere betrifft die vorliegende Erfindung ein Verfahren zum Anpassen eines ersten Referenzwertes. Der erste Referenzwert dient zum Generieren eines ersten Bitstromes aus einem Eingangssignal durch eine Amplitudenanpassungseinheit. Das Eingangssignal umfasst ein erstes Signal und ein zweites Signal. Das erste Signal weist eine erste Signalamplitude und das zweite Signal eine zweite Signalamplitude auf. Die erste Signalamplitude und die zweite Signalamplitude bilden eine Mischamplitude. Ein erstes nichtlineares Bauteil demoduliert das Eingangssignal und gibt als Mischsignal das demodulierte Eingangssignal aus. Die Amplitudenanpassungseinheit gibt basierend auf dem ersten Referenzwert aus dem Mischsignal bzw. dem demodulierten Eingangssignal einen ersten Bitstrom aus.

Weiterhin betrifft die vorliegende Erfindung insbesondere eine Schaltung zum Anpassen eines ersten Referenzwertes zum Generieren eines ersten Bitstromes aus einem Eingangssignal. Das Eingangssignal umfasst ein erstes Signal und ein zweites Signal, wobei das erste Signal eine erste Signalamplitude und das zweite Signal eine zweite Signalamplitude aufweist. Die erste Signalamplitude bildet mit der zweiten Signalamplitude eine Mischamplitude. Die Schaltung weist ein erstes nichtlineares Bauteil und eine erste Amplitudenanpassungseinheit auf. Das erste nichtlineare Bauteil ist ausgebildet, das Eingangssignal zu demodulieren und ein demoduliertes Eingangssignal auszugeben. Die erste Amplitudenanpassungseinheit ist ausgebildet, aus dem demodulierten Eingangssignal basierend auf dem ersten Referenzwert den ersten Bitstrom zu generieren.

Zum Empfang von Eingangssignalen und Demodulieren von Signalen, insbesondere durch ein kontaktloses Sicherheitsmodul, sind unterschiedliche Verfahren bekannt. Eine Empfangseinheit empfängt ein erstes Signal von einem Sende-/Empfangsgerät. Das empfangene erste Signal wird üblicherweise anhand eines Impedanzwandlers, insbesondere einer Vorrichtung und/ oder Einheit zur Vervielfachung einer Spannung, modifiziert. Über den Impedanzwandler wird eine Amplitude, insbesondere eine Spannungsamplitude, des empfangenen ersten Signals erhöht. Wenn es sich bei dem ersten Signal um ein amplitudenmoduliertes Signal handelt, wird mithilfe des Impedanzwandlers, der wenigstens ein nichtlineares Bauteil umfasst, das erste Signal demoduliert. Der Impedanzwandler ist üblicherweise ein Spannungsvervielfacher.

Zum Generieren eines Ausgabebitstroms aus dem ersten Signal wird es mittels einer Amplitudenanpassungseinheit verarbeitet. Die Amplitudenanpassungseinheit erstellt aus dem modifizierten ersten Signal einen Bitstrom des ersten Signals. Die Amplitudenanpassungseinheit umfasst üblicherweise einen Komparator, womit das demodulierte erste Signal in ein binäres Signal umgewandelt wird. Das demodulierte erste Signal wird darüber hinaus in einem zweiten Strompfad mittels einer Glättungseinheit geglättet und davon ein Referenzwert für den Komparator gebildet. Der Referenzwert, der vorzugsweise kleiner als die Spitzenamplitude des demodulierten ersten Signals am Eingang der Amplitudenanpassungseinheit ist, gilt als Bezugswert gegenüber dem demodulierten ersten Signal zum Generieren des ersten Ausgabebitstromes

Aufgrund stetigen Anstiegs drahtloser Kommunikation steigt die Anzahl von Signalen, die auf unterschiedlichen Trägerfrequenzen moduliert sind. Das kontaktlose Sicherheitsmodul empfängt oftmals neben dem ersten Signal weitere Signale, wenigstens ein zweites Signal. Besonders, wenn das zweite Signal eine zweite Trägerfrequenz aufweist, die nahe der ersten Trägerfrequenz des ersten Signals liegt und somit die erste Trägerfrequenz und die zweite Trägerfrequenz im gleichen Empfangsbereich des Sicherheitsmoduls sind und zudem das zweite Signal eine Amplitude in etwa der Größenordnung des ersten Signals aufweist, beeinflussen sich die beiden Trägerfrequenzen des ersten Signals und das zweite Signal gegenseitig derart, dass das Sicherheitsmodul aus dem Eingangssignal keinen eindeutigen Ausgabebitstrom betreffend das erste Signal generieren kann. In der Regel wird lediglich ein Störwert generiert. Eine Kommunikation zwischen Sende-/ Empfangsgerät und dem kontaktlosen Sicherheitsmodul ist nicht mehr sichergestellt.

Beispielsweise liegen die Frequenzbereiche von GSM und UHF-RFID nicht nur in unmittelbarer Nachbarschaft sondern überlappen sich teilweise. Beispielsweise senden ein UHF-RFID-Lesegerät im Frequenzbereich von 865 MHz und ein GSM-Mobiltelefon im Frequenzbereich von 880-915 MHz. Aufgrund einfacher Bauweise ist ein UHF-RFID-Transponder relativ breitbandig empfangsbereit. Der Empfangsbereich des UHF-RFID-Transponders ist gewöhnlich nur durch die Antenne begrenzt. Der UHF-RFID-Transponder kann somit sowohl UHF-RFID-Signale als auch GSM-Signale eines benachbarten Mobiltelefons empfangen. Beide Signale überlagern sich. Der UHF-RFID-Transponder des Standes der Technik kann die UHF-RFID-Signale nicht separieren und dekodieren. Eine Kommunikation zwischen dem UHF-RFID-Transponder und einem UHF-RFID-Sende-/Empfangsgerät ist nicht möglich, sobald die Amplitude des GSM-Signals im Verhältnis zu dem UHF-RFID-Signal eine Grenzamplitude überschreitet.

Aufgabe der Erfindung ist, die Nachteile des Standes der Technik zu beheben. Insbesondere ist es Aufgabe, einen verbesserten Empfang eines Sicherheitsmoduls bereitzustellen, wodurch eine Kommunikation zwischen einem Sende-/Empfangsgerät und dem Sicherheitsmodul bei Empfang wenigstens eines zweiten Signals im gleichen Empfangsbereich wie das erste Signal möglich ist.
Diese Aufgabe wird mit einem Verfahren und einer Schaltung gemäß den unabhängigen Ansprüchen gelöst. Vorteilhafte Ausgestaltungen sind in den Unteransprüchen aufgeführt.
Bei einem erfindungsgemäßen Verfahren zum Anpassen eines ersten Referenzwertes zum Generieren eines ersten Bitstromes aus einem Eingangssignal, das ein erstes und ein zweites Signal umfasst. Ein erstes nichtlineares Bauteil demoduliert das Eingangssignal und gibt ein demoduliertes Eingangssignal aus. Weiterhin gibt das erste nichtlineare Bauteil ein Basisband-Summensignal aus. Eine Amplitudenanpassungseinheit gibt basierend auf dem ersten Referenzwert aus dem demodulierten Eingangssignal den ersten Bitstrom aus. Erfindungsgemäß detektiert eine Detektionseinheit das erste und zweite Signal. Eine Referenzwertanpassungseinheit bewirkt bei Wegfall des ersten und zweiten Signals ein Angleichen des ersten Referenzwertes, insbesondere dessen Amplitude, auf einen Grundreferenzwert.
Das Basisband-Summensignal ist im Wesentlichen die Summe der Einhüllenden des Betrags der hochfrequenten ersten und zweiten Signale bzw. des Eingangssignals. Die Summenamplitude ist höher als die Signalamplitude des ersten oder zweiten Signals. Vorzugsweise handelt es sich beim ersten Signal um ein amplitudenmoduliertes Signal, beispielsweise ein UHF-RFID-Signal und beim zweiten Signal um kein amplitudenmoduliertes Signal, beispielsweise um ein GMSK-moduliertes Signal. Bei dem Wegfallen des ersten und/ oder zweiten Signals handelt es sich um ein Unterschreiten einer Mindestamplitude. Es ist somit als Taldurchlauf zu verstehen. Das Wegfallen des ersten und zweiten Signals findet nicht zwingend gleichzeitig statt. Insbesondere können das erste und zweite Signal zeitlich unterschiedlich abfallen. Das Wegfallen des ersten und zweiten Signals beschreibt somit einen Zustand, bei dem sowohl im Amplitudenverlauf des ersten Signals als auch im Amplitudenverlauf des zweiten Signals ein 0-Pegel bzw. ein Low-Signal gleichzeitig vorliegt.

Eine erfindungsgemäße Schaltung zum Anpassen eines ersten Referenzwertes zum Generieren eines ersten Bitstromes aus einem Eingangssignal umfasst ein erstes nichtlineares Bauteil und eine erste Amplitudenanpassungseinheit. Das Eingangssignal umfasst ein erstes Signal und ein zweites Signal. Das erste Signal weist eine erste Signalamplitude und das zweite Signal eine zweite Signalamplitude auf. Die erste Signalamplitude bildet mit der zweiten Signalamplitude eine Mischamplitude. Das erste nichtlineare Bauteil ist ausgebildet, das Eingangssignal zu demodulieren und ein demoduliertes Eingangssignal auszugeben. Die erste Amplitudenanpassungseinheit ist ausgebildet, aus dem demodulierten Eingangssignal basierend auf einem ersten Referenzwert den ersten Bitstrom zu generieren. Erfindungsgemäß umfasst die Schaltung eine Detektionseinheit und eine Angleicheinheit. Die Detektionseinheit ist ausgebildet festzustellen, ob im Eingangssignal das erste Signal und/ oder das zweite Signal vorhanden ist. Die Angleicheinheit ist ausgebildet, den ersten Referenzwert auf einen Grundreferenzwert anzupassen, wenn das zweite Signal wegfällt.
Der Empfang von lediglich einem Signal kann nicht immer gewährleistet werden. Es kann vorkommen, dass wenigstens zwei Signale im Eingangssignal enthalten sind. Falls eines der wenigstens zwei Signale wegfällt, insbesondere das zweite Signal, ist durch die Erfindung gewährleistet, dass in diesem Fall der erste Bitstrom entsprechend dem Signalverlauf des ersten Signals generiert wird. Insbesondere wird mithilfe der Angleicheinheit ein schnelles Anpassen des ersten Referenzwertes an veränderte Bedingungen im Eingangssignal ermöglicht, wobei die Qualität des ersten Referenzwertes erhalten, bspw. als Gleichspannungssignal, bleibt.

Das erfindungsgemäße Verfahren und die erfindungsgemäße Schaltung findet vorzugsweise Anwendung in einem Sicherheitsmodul. Grundsätzlich kann das Sicherheitsmodul in einem tragbaren Datenträger, nachfolgend auch Tag genannt, wie einer Chipkarte, einer sicheren Massenspeicherkarte oder einem USB-Token, verkörpert sein. Beispielsweise kann das Sicherheitsmodul eine Identitätskarte und/ oder eine Fahrkarte sein. Das Sicherheitsmodul kann die Form eines Etiketts aufweisen. Es kann auch fest in einem Modul oder Körper eingebaut, wie ein Trusted Platform Module (TPM), ein M2M-Modul, ein Benutzer-Identifikations-Modul oder ein Decoder-Modul, sein. Das Sicherheitsmodul kann zur Integration in einem Notebook, Handy, Computer oder Tastatur vorgesehen sein. Vorzugsweise weist das Sicherheitsmodul einen Prozessor und einen Speicher auf. Das Sicherheitsmodul ist insbesondere zur Kommunikation über eine Luftschnittstelle, bspw. in einem Frequenzbereich von RFID, insbesondere UHF-RFID, ausgebildet. Das Sicherheitsmodul kann als UHF-RFID-Modul, vorzugsweise als UHF-RFID-Transponder, ausgebildet sein. Das Sicherheitsmodul kann ein Teil eines UHF-RFID-Tags bzw. eines UHF-RFID-Etiketts sein.

Das erste und/ oder zweite Signal wird von einem Sende-/Empfangsgerät versandt. Ein Sende-/ Empfangsgerät, nachfolgend auch Sender benannt, dient zur Kommunikation mit dem Sicherheitsmodul. Das Sende-/Empfangsgerät kann ein Kartenleser, insbesondere als mobile Einheit, beispielsweise als Zubehör an einem Kassensystem, an einem Computer oder einem Mobiltelefon, als festinstalliertes Gerät, insbesondere zur Zugangskontrolle, oder als integrierte Einheit in einem Notebook, Mobiltelefon, Computer oder Tastatur vorgehalten sein.

Bei einem nichtlinearen Bauteil handelt es sich um ein elektrisches und/ oder elektronisches Bauteil mit einer nichtlinearen Beziehung zwischen Strom und Spannung. Eine Strom-Spannungs-Kennlinie verläuft entsprechend unlinear. Bei einem nichtlinearen Bauteil kann es sich lediglich um ein einzelnes Bauelement oder auch um ein nichtlineares Netzwerk handeln. Das nichtlineare Netzwerk umfasst Bauelemente, deren Zusammenschaltung eine nichtlineare Strom-Spannungs-Kennlinie ergibt. Ein nichtlineares Bauteil kann eine Gleichrichterdiode, ein Collector-Emitter-Übergang eines Transistors oder eine Röhre sein. Ein nichtlineares Netzwerk kann eine Zusammenschaltung von Gleichrichterdioden sein. Beispielsweise ist ein Spannungsvervielfacher mit einer Diodenschaltung bzw. einer Ladungspumpe ein nichtlineares Netzwerk.

Mit der vorliegenden Erfindung ist es nunmehr unter anderem möglich, in der Nähe eines UHF-RFID-Transponders ein Mobilfunktelefon unter Nutzung von GSM-Diensten zu betreiben, ohne die Kommunikation zwischen UHF-RFID-Sende-/Empfangsgerät und dem UHF-RFID-Transponder zu beeinflussen, insbesondere zu stören. Somit kann der UHF-RFID-Transponder nicht durch GSM-Signale in seiner Kommunikation negativ beeinträchtigt, insbesondere gestört, werden.

In einer Ausführungsform kann vorgesehen sein, dass die Angleicheinheit den ersten Referenzwert entsprechend dem Verlauf der Summenamplitude angleicht. Insbesondere bei wechselnder Signalamplitude des ersten und/ oder zweiten Signals, beispielsweise bei unterschiedlicher Empfangsqualität des ersten und/ oder zweiten Signals, könnte sich die Summenamplitude stetig verändern. Entsprechend ist eine direkte Anpassung des ersten Referenzwertes vorteilhaft. Zur direkten Anpassung könnte die Detektionseinheit das erste und/ oder zweite Signal, insbesondere deren Signalamplituden und/ oder die Summenamplitude, analysieren. Vorzugsweise ist der erste Referenzwert an die Summenamplitude gekoppelt.

In einer Ausführung umfasst die Angleicheinheit eine Schalteinheit. Die Schalteinheit könnte ein elektronischer Schalter, beispielsweise ein Feldeffekttransistor oder ein Bipolar-Transistor, sein. Über die Schalteinheit wird ein vorbestimmter Grundreferenzwert als erster Referenzwert der Amplitudenanpassungseinheit zugewiesen. Die Schalteinheit kann mehrpolig ausgeführt sein. Entsprechend verschiedenen Ergebnissen der Detektionseinheit aus der Summenamplitude kann ein Grundreferenzwert aus einer Vielzahl an Grundreferenzwerten als erster Referenzwert geschaltet werden. Die Angleicheinheit kann vorzugsweise in Verbindung mit der Detektionseinheit einen Steuerkreis, vorzugsweise einen Regelkreis, umfassen, wodurch eine stufenlose Anpassung des ersten Referenzwertes möglich ist. Unter anderem kann die Angleicheinheit eine Sensorik bezüglich des ersten Bitstromes umfassen.

Der Grundreferenzwert kann durch eine Konstantspannungsquelle festgelegt werden. Weiterhin wäre denkbar, den Grundreferenzwert in Abhängigkeit der Summenamplitude, des ersten Signals und/ oder des zweiten Signals einzustellen.

In einer Ausführungsform kann die Detektionseinheit eine Spannungsdifferenz zwischen dem Grundreferenzwert und der Summenamplitude ermitteln. Aus der Spannungsdifferenz erkennt die Detektionseinheit, ob das erste und/ oder zweite Signal im Eingangssignal enthalten ist. Die Detektionseinheit kann einen zweiten Komparator umfassen. Der zweite Komparator ist vorzugsweise ein Operationsverstärker. Dem zweiten Komparator kann der Grundreferenzwert als zweiter Referenzwert bereitgestellt werden. Ausgehend von der Spannungsdifferenz steuert die Detektionseinheit die Schalteinheit. Wenn beispielsweise die Spannungsdifferenz groß ist, bedeutet dies, dass das zweite Signal im Eingangssignal enthalten ist. Die Schalteinheit wird nicht betätigt. Ist hingegen die Spannungsdifferenz klein, oder vorzugsweise die Summenamplitude kleiner als der Grundreferenzwert, wird die Schalteinheit aktiviert.
Das erste Signal kann auf einer ersten Trägerfrequenz und das zweite Signal auf einer zweiten Trägerfrequenz moduliert sein. Das erste Signal und das zweite Signal bilden ein Mischsignal. Das Mischsignal umfasst das erste Signal, das zweite Signal und ein Mischprodukt aus dem ersten Signal und dem zweiten Signal auf einer Zwischenfrequenz. Ein zweites nichtlineares Bauteil demoduliert das Mischprodukt. Eine zweite Amplitudenanpassungseinheit generiert aus dem Signalverlauf des demodulierten Mischprodukts einen zweiten Bitstrom betreffend das erste Signal.
Es kann vorgesehen sein, dass das Mischsignal am ersten nichtlinearen Bauteil abgegriffen wird. Der Abgreifpunkt kann mit dem Basisband-Summensignal übereinstimmen. Zusätzlich könnte ein separater Abgreifpunkt zur Ausgabe des Mischsignals am ersten nichtlinearen Bauteil ausgebildet sein. Alternativ kann ein weiteres nichtlineares Bauteil, vorzugsweise ein Mischer, vorgesehen sein.

Bei einer Mischamplitude handelt es sich um eine Amplitude in einem Mischsignal, das aus dem ersten und zweiten Signal durch gegenseitige Beeinflussung gebildet wird.

Aufgrund unterschiedlicher Trägerfrequenzen der ersten Trägerfrequenz und der zweiten Trägerfrequenz wird durch das erste nichtlineare Bauteil das Mischsignal gebildet. In dem Mischsignal sind Mischprodukte des ersten und zweiten Signals enthalten. Die Mischprodukte sind auf Zwischenfrequenzen (k x f1 + m x f2) sowie |k x f1 - m x f2| mit k, m = 0, 1, 2, 3, .... In der Regel steigt mit Abstand der Zwischenfrequenzen von den Trägerfrequenzen die Ordnung der Zwischenfrequenz. D.h., die erste Ordnung gilt für k + m = 2. Die Zwischenfrequenzen erster Ordnung wären z.B. 2 x f1, 2 x f2, 1 x f1 + 1 x f2 und |f1 - f2|. Die Zwischenfrequenzen zweiter Ordnung (k + m = 3) gilt beispielsweise für die Zwischenfrequenzen 3 x f1, 3 x f2, |1 x f1 ± 2 x f2| und |2 x f1 ± 1 x f2|. Als Zwischenfrequenz sind somit ganzzahlige Vielfache von Summen und Differenzen der ersten und zweiten Trägerfrequenz möglich. Zwischenfrequenzen sind ähnlich Seitenbänder; sie sind jedoch auch ein ganzzahliges vielfaches der Trägerfrequenzen der Seitenbänder. Bei der Zwischenfrequenz kann es sich um genau eine Frequenz handeln. Eine Zwischenfrequenz kann auch ein Frequenzspektrum bzw. einen Frequenzbereich festlegen, in dem das Mischprodukt auftritt. Zum Beispiel kann die Trägerfrequenz des ersten und/ oder zweiten Signals innerhalb festgelegter Grenzen sein. Beispielsweise handelt es sich bei dem ersten und/ oder zweiten Signal um ein Signal mit einer möglichen Trägerfrequenz in einem Frequenzbereich von 880 MHz bis 915 MHz. Die Mischamplitude der Mischprodukte ist im Wesentlichen ein Produkt aus den Signalamplituden des ersten und zweiten Signals sowie einen konstanten Faktor. Der Verlauf des ersten Signals ist im Mischprodukt enthalten. Insbesondere der Verlauf eines amplituden- oder frequenzmodulierten ersten Signals bei gleichzeitigem Empfang eines bspw. phasenmodulierten zweiten Signals bleibt erhalten. Eine Überlagerung der ersten und zweiten Trägerfrequenz ist im Mischprodukt nicht enthalten. Die Amplitude der Mischprodukte sinkt mit ansteigender Ordnung. Somit weisen Mischprodukte erster Ordnung die größte Amplitude auf. Jedes der Mischprodukte kann mit dem zweiten Demodulator, der zum Demodulieren des ersten Signals geeignet ist, ohne Beeinflussung durch das zweite Signal demoduliert werden.

Der zweite Bitstrom entspricht dann dem Signalverlauf des ersten Signals, während das zweite Signal empfangen wird. Eine Ausgabelogik wechselt entsprechend vom ersten Bitstrom auf den zweiten Bitstrom zur Ausgabe des Bitstroms des ersten Signals. Die zweite Amplitudenanpassungseinheit kann analog oder ähnlich der ersten Amplitudenanpassungseinheit aufgebaut sein. Der zweiten Amplitudenanpassungseinheit kann eine Einheit, ähnlich der Referenzwertanpassungseinheit, umfassen, um einen zweiten Referenzwert der zweiten Amplitudenanpassungseinheit bereitzustellen.

Die Konstantspannungsquelle kann als separate Spannungsquelle ausgebildet sein. Beispielsweise kann die Konstantspannungsquelle eine Batterie oder einen Akkumulator umfassen. Vorzugsweise ist die Konstantspannungsquelle mit dem Eingangssignal gekoppelt und generiert aus dem Eingangssignal eine konstante Ausgabespannung. Die Konstantspannungsquelle kann eine Zener-Diode, einen Spannungsregler, eine Ladungspumpe und/ oder einen Spannungsteiler umfassen. Die Konstantspannungsquelle ist vorzugsweise auf eine Ausgabespannung festgelegt, welche der maximalen Signalamplitude des ersten Signals entspricht. Die Konstantspannungsquelle kann beschaltet sein, dass die Ausgabespannung der Konstantspannungsquelle über einen ohmschen Widerstand an der Amplitudenanpassungseinheit als Grundreferenzwert anliegt.
Die Erfindung wird im Folgenden noch weiter beispielhaft an Hand der Zeichnungen erläutert. Es zeigen:
- Fig. 1: ein Blockschaltbild eines Ausführungsbeispiels gemäß der Erfindung;
- Fig. 2: eine detaillierte Darstellung eines Ausführungsbeispiels gemäß der Erfindung;
- Fig. 3: ein schematisches Frequenzdiagramm zu der Schaltung aus Figur 2;
- Fig. 4: eine Erweiterung der Schaltung aus Fig. 2
- Fig. 5a: ein Anwendungsbeispiel für den Einsatz der Erfindung zur Reichweitenerhöhung von Sicherheitsmodulen;
- Fig. 5b: ein Ausführungsbeispiel zur Steuerung der Reichweitenerhöhung; und
- Fig. 6: eine Steuerungsschema des Anwendungsbeispiels aus Fig. 5a.

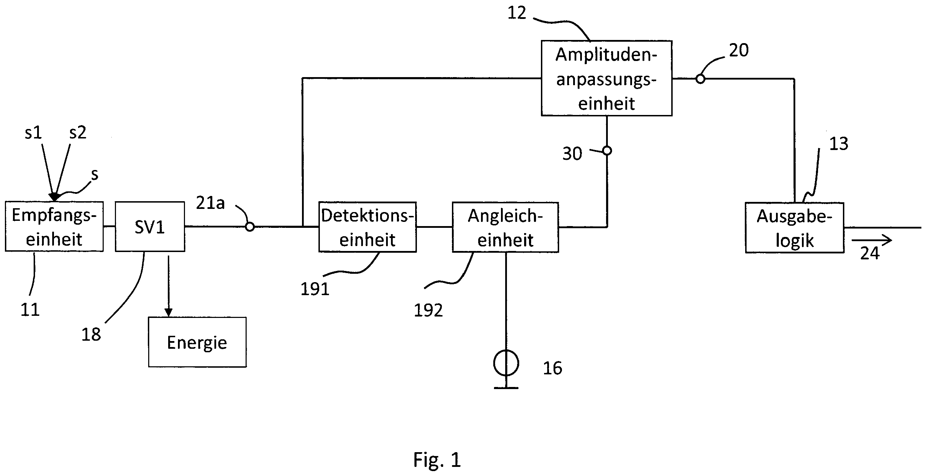

In der Fig. 1 ist ein Blockschaltbild zu einer Ausführungsform gemäß der Erfindung dargestellt.
Eine Empfangseinheit 11 empfängt ein Eingangssignal s. Das Eingangssignal s umfasst ein erstes Signal s1 mit einer ersten Signalamplitude und ein zweites Signal s2 mit einer zweiten Signalamplitude. Das erste Signal s1 ist in diesem Ausführungsbeispiel ein UHF-RFID-Signal auf einer ersten Trägerfrequenz f1 von ca. 865 MHz. Das zweite Signal s2 ist ein GSM-Signal auf einer zweiten Trägerfrequenz f2 von ca. 915 MHz. Das Eingangssignal s wird von der Empfangseinheit 11 an ein erstes nichtlineares Bauteil 18, vorliegend ein Spannungsvervielfacher (SV) 18, weitergegeben.
Der Spannungsvervielfacher 18 ist ähnlich einer Ladungspumpe aufgebaut und umfasst eine Zusammenschaltung von Dioden und Kondensatoren. Der erste Spannungsvervielfacher 18 weist aufgrund seiner unlinearen Kennlinie die Funktion eines elektronischen Mischers auf. Der erste Spannungsvervielfacher 18 erzeugt aus dem Eingangssignal s ein Basisband-Summensignal 21a. Der erste Spannungsvervielfacher 18 demoduliert das Eingangssignal s. Das Basisband-Summensignal 21a wird einer ersten Amplitudenanpassungseinheit 12 weitergeleitet. Die erste Amplitudenanpassungseinheit 12 generiert aus dem Basisband-Summensignal 21a einen ersten Bitstrom 20, basierend auf ein erstes Referenzsignal. Dazu wertet die erste Amplitudenanpassungseinheit 12 das Basisband-Summensignal 21a in Bezug auf das erste Referenzsignal aus. Die erste Amplitudenanpassungseinheit 12 vergleicht vorzugsweise eine Amplitude des Basisband-Summensignals 21a mit einer Amplitude des ersten Referenzsignals.
Das erste Referenzsignal wird in dieser Ausführungsform ausschließlich durch eine Angleicheinheit 192 generiert. Insbesondere handelt es sich bei dem ersten Referenzsignal um eine Gleichspannungsamplitude. Das Referenzsignal ist vom ersten und zweiten Signal s1, s2 abhängig. Im Basisband-Summensignal 21a ist der Verlauf des amplitudenmodulierten Signals s1 enthalten. Zur Generierung des ersten Referenzwertes wird das Basisband-Summensignal 21a in ein möglichst homogenes Gleichspannungssignal mit geringen Schwankungen gewandelt.

Die erste Amplitudenanpassungseinheit 12 generiert ausgehend aus Amplitudenänderungen im Basisband-Summensignal 21a im Bezug zum ersten Referenzsignal den ersten Bitstrom 20. Die erste Amplitudenanpassungseinheit 12 vergleicht die Amplitude des Basisband-Summensignal 21a mit der Amplitude des ersten Referenzsignals und gibt entsprechend eines Binärsignals mit einem 1-Signal oder 0-Signal den ersten Bitstrom 20 aus.

Parallel zur ersten Amplitudenanpassungseinheit 12 wird das Basisband-Summensignal 21a einer Referenzwertanpassungseinheit 19 weitergeleitet. Die Referenzwertanpassungseinheit 19 umfasst eine Detektionseinheit 191, die Angleicheinheit 192 und in diesem Ausführungsbeispiel eine Konstantspannungsquelle 16. Die Detektionseinheit 191 analysiert das Basisband-Summensignal 21a. Insbesondere erkennt die Detektionseinheit 191, ob, wann und/ oder in welchem Rahmen das zweite Signal s2 nicht mehr empfangen wird. Ausgehend von dem Ergebnis der Detektionseinheit 191 steuert die Angleicheinheit 192 die Amplitude des ersten Referenzsignals. Die Angleicheinheit 192 bewirkt mithilfe der Konstantspannungsquelle 16, dass das erste Referenzsignal eine bestimmte Spannungsamplitude aufweist. Das erste Referenzsignal bildet einen ersten Referenzwert der ersten Amplitudenanpassungseinheit 12. Mithilfe der Angleicheinheit 192 und der Detektionseinheit 191 kann der erste Referenzwert auf einen Wert eingestellt werden, um den ersten Bitstrom aus dem Basisband-Summensignal 21a zu generieren. Die Spannungsamplitude der Konstantspannungsquelle 16 entspricht somit einem Grundreferenzwert für die Amplitudenanpassungseinheit 12. Insbesondere kann schnell auf Änderungen im Basisband-Summensignal 21a, insbesondere auf Änderungen des ersten und/ oder zweiten Signals s1, s2, bspw. bei einem gemeinsamen Wegfall des ersten und zweiten Signals s1, s2, reagiert werden.

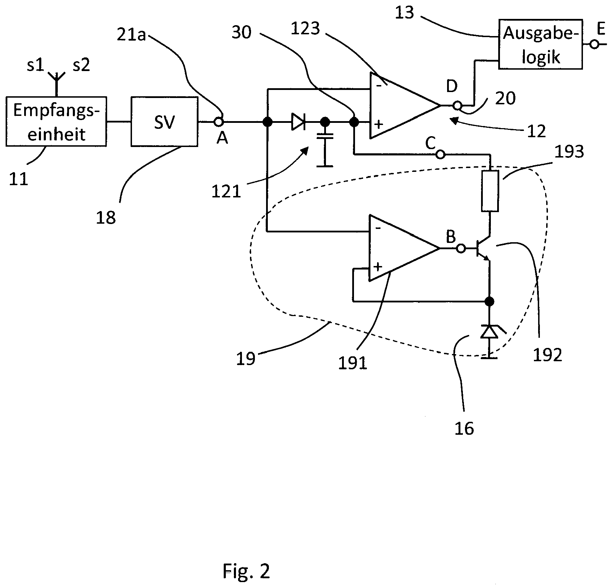

In der Figur 2 ist ein weiteres Ausführungsbeispiel anhand einer Schaltung dargestellt. Im Besonderen unterscheidet sich dieses Beispiel von der Figur 1 in der Bereitstellung des Referenzwertes sowie im Detailgrad der Schaltung. Eine Empfangseinheit 11 empfängt ein Eingangssignal s, das ein erstes und ein zweites Signal s1, s2 umfasst. Das Eingangssignal s wird einem nichtlinearen Bauteil 18 weitergeleitet. Im vorliegenden Fall ist das nichtlineare Bauteil 18 ein erster Spannungsvervielfacher 18. Der erste Spannungsvervielfacher 18 vergrößert die Amplituden im Eingangssignal s. Gleichzeitig weist der erste Spannungsvervielfacher 18 aufgrund seiner Nichtlinearität die Funktion eines Demodulators und Mischers auf. Der erste Spannungsvervielfacher 18 erstellt ein Basisband-Summensignal 21a. Das Basisband-Summensignal 21a umfasst die Summe der Einhüllenden der Beträge der ersten und zweiten Signale s1, s2. Das Basisband-Summensignal 21a wird an die erste Amplitudenanpassungseinheit 12, welche einen ersten Komparator 123 und einen Referenzwertgenerator 121 umfasst, weitergeleitet. Das Basisband-Summensignal 21a liegt an einem Eingang des ersten Komparators 123 an.
Weiterhin wird das Basisband-Summensignal 21a dem Referenzwertgenerator 121 zugeführt. Der Referenzwertgenerator 121 weist eine Gleichrichterdiode und einen ersten Kondensator auf. Der Referenzwertgenerator 121 liefert einen ersten Referenzwert an den ersten Komparator 123. Der erste Referenzwert entspricht im Wesentlichen dem Gleichspannungsanteil im Basisband-Summensignal 21a abzüglich der Durchlassspannung der Gleichrichterdiode. Mithilfe des Kondensators wird der Referenzwert zusätzlich geglättet. Der erste Referenzwert ist demnach geringer als ein Spitzenwert der Amplitude im Basisband-Summensignal 21a.
Die Referenzwertanpassungseinheit 19 ist im Wesentlichen parallel zum Referenzwertgenerator 121 geschaltet. Die Referenzwertanpassungseinheit 19 umfasst einen zweiten Komparator 191, eine Angleicheinheit 192 in Form eines elektronischen Schalters 192, einen Lastwiderstand 193 und eine Konstantspannungsquelle 16. Das Basisband-Summensignal 21a wird einem Eingang (negativer Eingang) des zweiten Komparators 191 zugeführt. Der zweite Eingang (positiver Eingang) des zweiten Komparators 191 ist mit der Konstantspannungsquelle 16 verbunden. Der Ausgang des zweiten Komparators 191 steuert den elektronischen Schalter 192.
Der elektronische Schalter 192 kann den positiven Eingang des ersten Komparators 123, der den Referenzwert aufnimmt, mit der Konstantspannungsquelle 16 verbinden. Der elektronische Schalter 192 ermöglicht, dass das Potential der Konstantspannungsquelle 16 dem ersten Komparator 123 als erster Referenzwert zugeführt wird.
Vorzugsweise entspricht das Potential der Konstantspannungsquelle 16 0,4 - 0,6 V. Der Referenzwertgenerator 121 erzeugt den generierten Referenzwert, der vom Basisband-Summensignal 21a, d.h. vom ersten und zweiten Signal s1, s2 abhängt. Wird nur ein Signal empfangen ist der erste Referenzwert niedriger als wenn das erste und zweite Signal s1, s2 empfangen werden. Aufgrund des Kondensators des Referenzwertgenerators 121 werden Spitzenamplituden geglättet. Ein Anstieg der Amplitude im Basisband-Summensignal 21a wird schnell berücksichtigt. Nachdem das erste und zweite Signal s1, s2 von der Empfangseinheit 11 empfangen wurden, bedingt ein Wegfall eines Signals im Basisband-Summensignal 21a eine Reaktionsverzögerung durch Entladen des Kondensators. Um den Kondensator schnellstmöglich zu entladen, jedoch dem ersten Referenzwert ein bestimmtes Potential zu halten, wird bei Wegfall eines Signals, vorzugsweise des zweiten Signals s2, der elektronische Schalter 192 geschalten. Das Spannungspotential der Konstantspannungsquelle 16 wird zum Referenzwertgenerator 121 geführt. Der Kondensator des Referenzwertgenerators 121 wird über die Konstantspannungsquelle 16 im Wesentlichen auf deren Potential entladen. Das Spannungspotential der Konstantspannungsquelle 16 wird als erster Referenzwert dem ersten Komparator 123 bereitgestellt.

Der erste Komparator 123 kann schnell auf Änderungen des Eingangssignals s, insbesondere auf ein Wegfallen des zweiten Signals s2, reagieren. Der erste Komparator 123 kann unmittelbar nach Wegfallen des ersten oder zweiten Signals s1, s2 aus dem Eingangssignal s einen ersten Bitstrom 20 generieren und den ersten Bitstrom 20 einer Ausgabelogik 13 zur Ausgabe eines Bitstroms des ersten Signals s1 als Ausgabebitstrom bereitstellen.

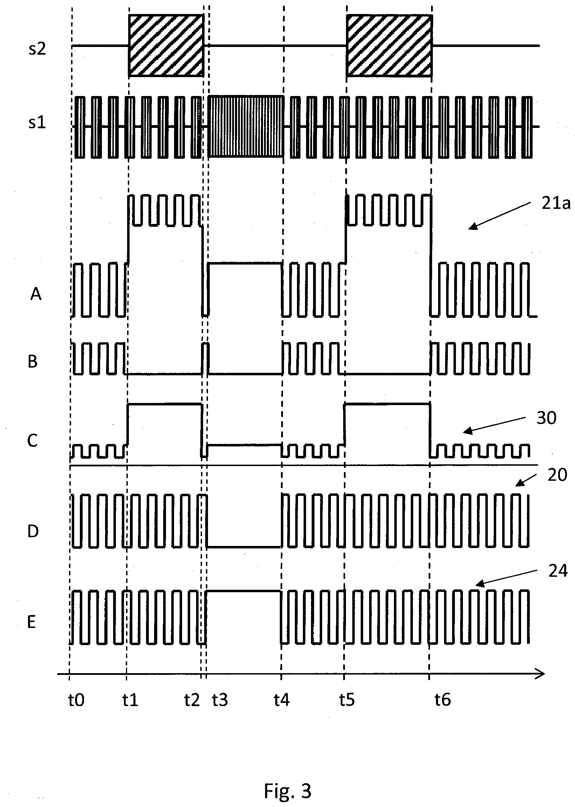

In der Figur 3 sind Signalverläufe an Messpunkte A bis E der Figur 2 in den Zeitbereichen t0 bis t6 dargestellt. Nachfolgend werden Betriebssituationen entsprechend den Zeitbereichen t0 bis t6 mit Bezug auf die Figuren 2 und 3 beschrieben.

Im Zeitintervall t0 bis t1 empfängt die Eingangseinheit 11 nur das erste Signal s1. Das Eingangssignal s enthält nur das erste Signal s1. Der erste Spannungsvervielfacher (SV) 18 erhöht die Amplitude des Eingangssignals s und demoduliert das Eingangssignal s. Das Basisband-Summensignal 21a am Ausgang des ersten Spannungsvervielfachers 18 enthält lediglich das erhöhte, demodulierte Eingangssignal s (vgl. Messpunkt A). Der Referenzwertgenerator 121 erhält das Basisband-Summensignal 21a und generiert aus dem Basisband-Summensignal 21a einen ersten Referenzwert. Der erste Referenzwert würde im Wesentlichen dem Gleichspannungsanteil im Basisband-Summensignal 21a entsprechen.

Das Basisband-Summensignal 21a liegt zudem am negativen Eingang des zweiten Komparators 191 der Referenzwertanpassungseinheit 19 an. Am positiven Eingang des zweiten Komparators 191 liegt das Potential der Konstantspannungsquelle 16 an. Der zweite Komparator 191 gibt ein 1-Signal aus, wenn der Signalverlauf des Basisband-Summensignal 21a und somit das ersten Signals s1 ein Tal durchläuft (vgl. Messpunkt B). Der zweite Komparator 191 schaltet entsprechend den elektronischen Schalter 192, wodurch das Potential des ersten generierten Referenzwerts des Referenzwertgenerators 121 auf das Spannungspotential der Konstantspannungsquelle 16 abgeglichen wird. Mit anderen Worten wird das Spannungspotential des Kondensators des Referenzwertgenerators 121 bei Überschreiten des Spannungspotentials der Konstantspannungsquelle 16 schnell über den Lastwiderstand 193 an das Potential der Konstantspannungsquelle 16 angeglichen (vgl. Messpunkt C), wenn das erste Signal ein Tal durchläuft. Der Kondensator wird zumindest teilweise entladen. Dem ersten Komparator 123 wird entsprechend das Spannungspotential der Konstantspannungsquelle 16 als erster Referenzwert am positiven Eingang bereitgestellt. Somit entspricht der erste Referenzwert im Zeitintervall [t0;t1] dem Verlauf des demodulierten ersten Signals s1, d.h. dem Basisband-Summensignal 21a, mit einen DC-Offset (Gleichspannungsversatz).

Das Basisband-Summensignal 21a liegt ebenfalls am negativen Eingang des ersten Komparators 123 an. Ein Taldurchlauf (0-Amplitude) im Basisband-Summensignal 21a ergibt durch Bezug auf den Referenzwert durch die Amplitudenanpassungseinheit ein 1-Signal im ersten Bitstrom 20 (vgl. Messpunkt D). Der erste Komparator 123 gibt den ersten Bitstrom 20 aus. Die Ausgabelogik 13 erstellt aus dem ersten Bitstrom 20 den Bitstrom des ersten Signals s1 (vgl. Messpunkt E).

Im Zeitintervall [t1;t2] empfängt das Sicherheitsmodul sowohl das erste als auch das zweite Signal s2. Der erste Spannungsvervielfacher 18 generiert aus dem Eingangssignal s ein Basisband-Summensignal 21a. Die Amplitude des Basisband-Summensignals 21a ist signifikant höher als im Zeitintervall [t0;t1] (vgl. Messpunkte A). Insbesondere entspricht der Signalverlauf des Basisband-Summensignals 21a dem Verlauf bzw. dem Basisband des ersten Signals und umfasst einen Spannungsversatz proportional zur Amplitude des zweiten Signals s2.

Der Referenzwertgenerator 121 generiert aus dem Basisband-Summensignal 21a, wie bereits oben dargelegt, den ersten Referenzwert für den positiven Eingang des Komparators 123. Der erste Referenzwert in diesem Zeitintervall ist höher als im Zeitintervall [t0;t1]. Die Amplitude eines Taldurchlaufs im Basisband-Summensignal 21a ist höher als das Spannungspotential der Konstantspannungsquelle 16. Der zweite Komparator 191 liefert an seinem Ausgang ein "0"-Signal (vgl. Messpunkt B). Der erste elektronische Schalter 192 schaltet nicht. Am positiven Eingang des ersten Komparators 123 liegt somit der erste Referenzwert als maßgeblicher Referenzwert an (vgl. Messpunkt C). Der erste Komparator 123 generiert aus dem Basisband-Summensignal 21a in Bezug auf den ersten Referenzwert den ersten Bitstrom 20 (vgl. Messpunkt D). Der erste Bitstrom 20 wird der Ausgabelogik 13 zugeführt. Die Ausgabelogik 13 gibt den Bitstrom des ersten Signals s1 aus (vgl. Messpunkt E).

Die Empfangseinheit 11 hat während des Zeitintervalls t0 bis t2 ein moduliertes erstes Signal s1 empfangen. Während des Zeitintervalls [t2-t3] empfängt die Empfangseinheit 11 weder ein erstes Signal s1 noch ein zweites Signal s2. Am Ausgang des ersten Spannungsvervielfachers 18 liegt das Basisband-Summensignal 21a ohne ersten und zweiten Signal s1, s2 an, d. h. das Basisband-Summensignal 21a weist einen 0-Pegel auf. Der erste Referenzwertgenerator 121 hält vorerst den ersten Referenzwert für den ersten Komparator 123 aufrecht. Der zweite Komparator 191 vergleicht das Basisband-Summensignal 21a mit der Amplitude der Konstantspannungsquelle 16. Der zweite Komparator 191 gibt entsprechend ein 1-Signal aus (vgl. Messpunkt B) und schaltet den elektronischen Schalter 193. Der Kondensator des Referenzwertgenerators 121 wird über den elektronischen Schalter 193 und der Konstantspannungsquelle 16 auf deren Amplitude bzw. Spannungspotential entladen. Der erste Referenzwert entspricht der Amplitude der Konstantspannungsquelle 16, welche höher als die Amplitude des Basisband-Summensignals 21a ist. Der erste Komparator 123 gibt ein 1-Signal aus (vgl. Messpunkt D). Die Ausgabelogik 13 gibt entsprechend ein 0-Signal aus (vgl. Messpunkt E). Das Signal der Ausgabelogik 13 entspricht für das Zeitintervall [t2;t3] dem demodulierten Signalverlauf des ersten Signals s1.

Im Zeitintervall [t3;t4] empfängt die Empfangseinheit ein erstes Signal s1, das hinsichtlich einer Amplitudenmodulation zu 100% unmoduliert ist. Weiterhin wird kein zweites Signal s2 einer Trägerfrequenz von 915 MHz empfangen.

Der Referenzwertgenerator 121 generiert basierend auf das Basisband-Summensignal 21a den ersten Referenzwert. Das Basisband-Summensignal 21a weist keine Täler auf (vgl. Messpunkt A). Der erste Referenzwert entspricht dem ersten Referenzwert, der während Spitzenamplituden im Basisband-Summensignal 21a im Zeitintervall [t1;t2] generiert wurde. Im Wesentlichen entspricht der erste Referenzwert der Amplitude des ersten Signals s1 abzüglich der Durchlassspannung der Gleichrichterdiode des Referenzwertgenerators 121. Die Amplitude des Basisband-Summensignals 21a ist höher als die Amplitude der Konstantspannungsquelle 16. Der zweite Komparator 191 gibt ein "0"-Signal aus (vgl. Messpunkt B). Der elektronische Schalter 192 schaltet nicht. Am positiven Eingang des ersten Komparators 123 der Referenzwertanpassungseinheit 12 liegt der erste Referenzwert an (vgl. Messpunkt C) an, der von dem Referenzwertgenerator 121 bereitgestellt wird. Der erste Komparator 123 liefert an seinem Ausgang als ersten Bitstrom 20 ein dauerhaftes "0"-Signal bzw. Low-Signal (vgl. Messpunkt D). Die Ausgabelogik 13 generiert aus dem ersten Bitstrom 20 den Bitstrom des ersten Signals s1 (vgl. Messpunkt E).

Im Zeitintervall [t4;t5] empfängt die Empfangseinheit 11 wieder ein zu 100% amplitudenmoduliertes erstes Signal s1. Weiterhin wird kein zweites Signal s2 empfangen. Der Bitstrom des ersten Signals s1 am Ausgang der Ausgabelogik 13 wird analog zum Zeitintervall [t0;t1] generiert. Bei jedem Taldurchlauf im Basisband-Summensignal 21a gibt der zweite Komparator 191 ein "1"-Signal aus (vgl. Messpunkt B). Der elektronische Schalter 192 schaltet. Der Glättungskondensator des Referenzwertgenerators 121 wird auf das Spannungspotential der Konstantspannungsquelle 16 entladen. Der erste Referenzwert wird auf das Spannungspotential der Konstantspannungsquelle 16 festgelegt.

Im Zeitintervall [t5;t6] wird der Bitstrom des ersten Signals s1 analog zum Zeitintervall [t1;t2] generiert.

Wie aus dem dargelegten Ausführungsbeispiel zu erkennen ist, agiert die Referenzwertanpassungseinheit 19 nur, wenn die Amplitude des Mischsignals kleiner als die Spannungsamplitude der Konstantspannungsquelle 16 ist. D.h., die Referenzwertanpassungseinheit 19 beeinflusst nur dann den Referenzwertgenerator 121, wenn sowohl das erste Signal s1 als auch das zweite Signal s2 nicht von der Empfangseinheit 11 empfangen werden. In diesem Fall wird der Glättungskondensator des Referenzwertgenerators 121 auf ein von der Referenzwertanpassungseinheit 19, insbesondere der Konstantspannungsquelle 16, vorgegebenes Potential entladen.

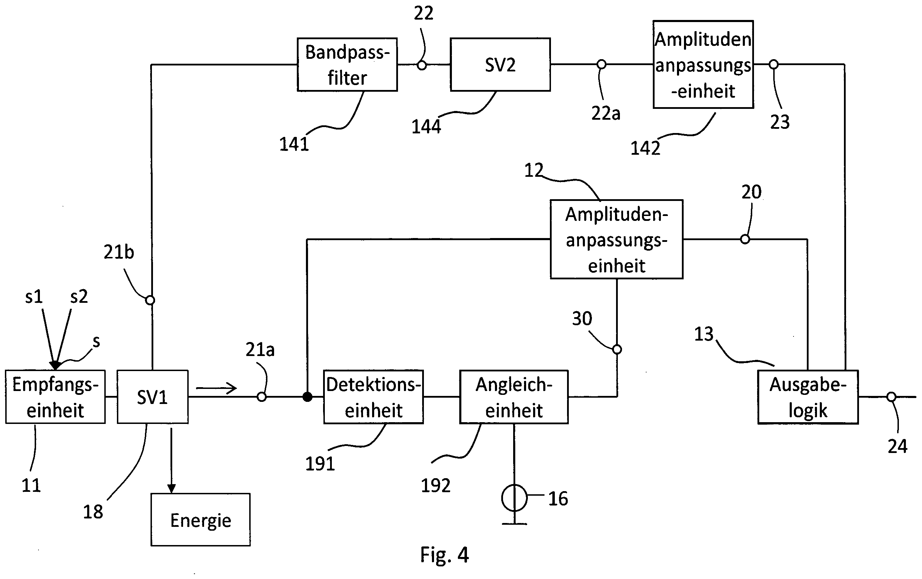

In der Figur 4 ist eine Erweiterung des in Figur 2 dargestellten Ausführungsbeispiels dargestellt. Im Detail ist ein Bandpassfilter 141, ein zweites nichtlineares Bauteil 144 in Form eines zweiten Spannungsvervielfachers 144 und eine zweite Amplitudenanpassungseinheit 142 hinzugefügt. Vorliegend wird die Eigenschaft des ersten Spannungsvervielfachers 18 eines elektronischen Mischers genutzt, dass vom ersten Spannungsvervielfacher 18 dem Bandpassfilter 141 ein Mischsignal 21b zugeführt wird. Vorzugsweise unterscheidet sich das Mischsignal 21b vom Basisband-Summensignal 21a. Das Bandpassfilter 141 filtert aus dem Mischsignal 21b ein Mischproduktsignal 22. Das Mischproduktsignal 22 wird dem zweiten Spannungsvervielfacher 144 zugeführt. Der zweite Spannungsvervielfacher 144 demoduliert das Mischproduktsignal 22, erhöht deren Amplitude und gibt ein Basisbandsignal 22a aus. Das Basisbandsignal 22a wird der zweiten Amplitudenanpassungseinheit 142 zugeführt. Die zweite Amplitudenanpassungseinheit 142 generiert aus dem Basisbandsignal 22a einen zweiten Bitstrom 23. Der zweite Bitstrom 23 wird der Ausgabelogik 13 zugeführt. Die Ausgabelogik 13 generiert aus dem ersten Bitstrom 20 und dem zweiten Bitstrom 23 den Bitstrom des ersten Signals s1. Insbesondere wechselt die Ausgabelogik 13 bei Anliegen des zweiten Bitstroms 23 zur Ausgabe des zweiten Bitstroms 23 als Bitstrom des ersten Signals s1. D.h., die Ausgabelogik gibt nur dann den zweiten Bitstrom 23 aus, wenn beim zweiten Bitstrom 23 ein Signal anliegt.

Mithilfe des ersten nichtlinearen Bauteils 18 (erster Spannungsvervielfacher 18) wird bei Empfang des ersten und zweiten Signals ein Basisband-Summensignal 21a und ein Mischsignal 21b generiert. Wird das zweite Signal s2 empfangen während kein Signalpegel des ersten Signals s1 anliegt, kann die erste Amplitudenanpassungseinheit 12 einen Bitfehler im ersten Bitstrom 20 generieren. Der Anstieg der Amplitude des Basisband-Summensignals 21a könnte durch den Empfang des zweiten Signals s2 von der ersten Amplitudenanpassungseinheit 12 als "1"-Signal des demodulierten ersten Signals s1 gewertet werden. Um diesen Bitfehler auszuschließen wird durch das Bandpassfilter 141 das Mischproduktsignal 22 aus dem Mischsignal 21b gefiltert. Das Mischproduktsignal 22 ist hinsichtlich anderen störenden Mischprodukten und Signalen bereinigt. Das erste Signal s1 liegt amplitudenmoduliert vor. Das zweite Signal s2 liegt nicht amplitudenmoduliert vor. Das Mischproduktsignal 22 wird durch den zweiten Spannungsvervielfacher 144 hinsichtlich des ersten Signals s1 demoduliert. Der zweite Spannungsvervielfacher 144 gibt das Basisbandsignal 22a aus. Das Basisbandsignal 22a umfasst das demodulierte erste Signal s1. Die zweite Amplitudenanpassungseinheit 142 generiert den zweiten Bitstrom 23 in Bezug auf einen zweiten Referenzwert. Der zweite Referenzwert kann aus dem Basisbandsignal 22a, ähnlich durch den Referenzwertgenerator 121, generiert werden. Zusätzlich könnte der zweite Referenzwert analog zum ersten Referenzwert mithilfe der oder einer ähnlichen Referenzwertanpassungseinheit generiert werden.

Die Ausgabelogik 13 erkennt, ob ein zweiter Bitstrom 23 generiert wird und schaltet entsprechend auf den zweiten Bitstrom 23 zur Ausgabe des Bitstroms des ersten Signals s1 um. Vorzugsweise wird bei Ausgabe des ersten Bitstroms 20 dieser negiert und als Bitstrom des ersten Signals s1 ausgegeben. Der Ausgabebitstrom der Ausgabelogik 13 entspricht dem Bitstrom des ersten Signals s1.

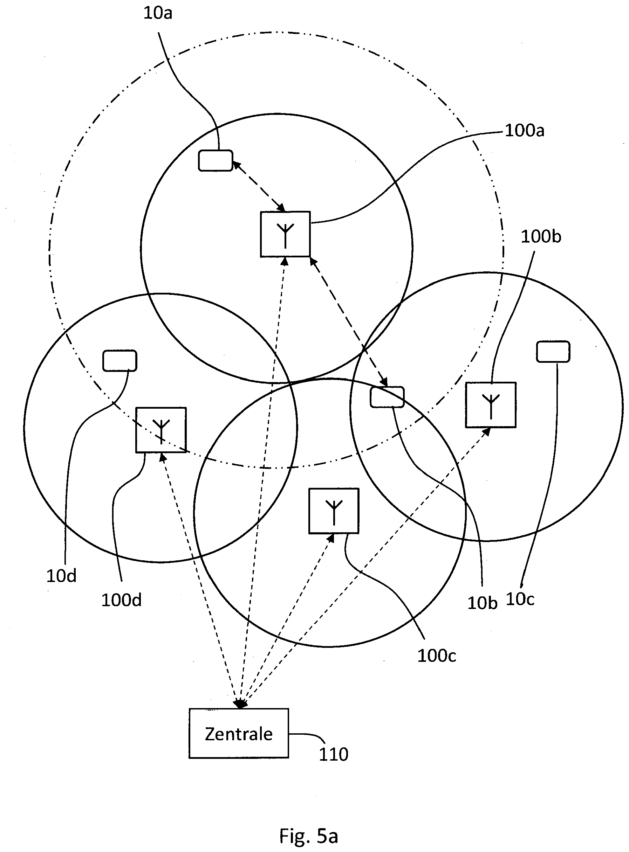

In Figur 5a ist ein Ausführungsbeispiel für eine Anwendung der Erfindung in UHF-RFID-Etiketten und -Tags zur Reichweitenerhöhung dargestellt.

Mehrere UHF-RFID-Sender 100a, 100b, 100c, 100d können jeweils von UHF-RFID-Etiketten 10a, 10b, 10c, 10d in einen bestimmten Umkreis (Kreise mit durchgezogener Linie um UHF-RFID-Sender 100a, 100b, a100c, 100d) Antworten empfangen. Die UHF-RFID-Etiketten 10a, 10b, 10c, 10d sind gemäß der Erfindung ausgestattet. Zur Kommunikation zwischen den UHF-RFID-Sendern 100a, 100b, 100c, 100d und den UHF-RFID-Etiketten 10a, 10b, 10c, 10d arbeiten die UHF-RFID-Etiketten 10a, 10b, 10c, 10d im elektromagnetischen Fernfeld, d. h. sie übermitteln Antworten mittels modulierter Rückstreuung. Die UHF-RFID-Etiketten 10a, 10b, 10c, 10d haben keine eigene Energieversorgung. Ihre Reichweite ist deshalb von dem elektromagnetischen Fernfeld abhängig. Das erste UHF-RFID-Etikett 10a kann im Feld des ersten UHF-RFID-Senders 100a mit diesem kommunizieren. Eine Kommunikation des ersten UHF-RFID-Etiketts 10a mit dem zweiten/dritten/vierten UHF-RFID-Sender 10b, 10c, 10d ist aber grundsätzlich nicht möglich. Das zweite UHF-RFID-Etikett 10b ist im Kommunikationsbereich des zweiten und dritten UHF-RFID-Senders 100b, 100c und kann mit diesen kommunizieren. Das vierte UHF-RFID-Etikett 10d ist lediglich im Kommunikationsbereich mit dem vierten UHF-RFID-Sender 100d. Damit das zweite UHF-RFID-Etikett 10b mit dem ersten UHF-RFID-Sender 100a kommunizieren kann, muss dem zweiten UHF-RFID-Etikett 10b mehr Energie bereitgestellt werden. Dazu kann das zweite UHF-RFID-Etikett 10b aus den elektromagnetischen Feldern der zweiten und dritten UHF-RFID-Sender 100b, 100c Energie entnehmen.

Der zweite und dritte UHF-RFID-Sender 100b, 100c senden jeweils ein unmoduliertes zweites und drittes Signal s2, s3 auf jeweils einer zweiten bzw. dritten Trägerfrequenz f2, f3. Der erste UHF-RFID-Sender 100a sendet eine Anfrage als moduliertes erstes Signal s1 auf einer ersten Trägerfrequenz f1 an das zweite UHF-RFID-Etikett 10b. Grundsätzlich liegen die erste, zweite und dritte Trägerfrequenz im gleichen Frequenzband und f1#2; f1#f3; f1≈f2; f1≈f3. Das modulierte erste Signal s1 sowie die unmodulierten Signale s2, s3 werden vom zweiten UHF-RFID-Etikett 10b empfangen. Aufgrund der zusätzlichen zweiten und dritten Signale s2, s3, die sich mit dem ersten Signal s1 überlagern, werden im zweiten UHF-RFID-Etikett 10b Mischprodukte gebildet. Die Mischprodukte können zur weiteren Signalverarbeitung von zweiten UHF-RFID-Etikett 10 genutzt werden. Der Energieinhalt des ersten, zweiten und dritten Signals s1, s2, s3 steht in Summe dem zweiten UHF-RFID-Etikett 10b zur Verfügung. Das zweite UHF-RFID-Etikett 10b empfängt das erste, zweite und dritte Signal s1, s2, s3 und generiert mithilfe der Erfindung einen Bitstrom des ersten Signals s1. Das zweite UHF-RFID-Etikett 10b erstellt eine erste Antwort.

Aufgrund der mehreren Signale, nämlich des ersten, zweiten und dritten Signals s1, s2, s3, erhält das zweite UHF-RFID-Etikett 10b eine, im Vergleich zu lediglich einem einzigen ersten Signal s1, höhere Energie zum Betrieb zur Verfügung. Die Rücksendereichweite ist grundsätzlich nicht erhöht. Aufgrund der Energie des ersten UHF-RFID-Senders 100a reicht diese aus, um das Rücksendesignals bzw. die erste Antwort auszuwerten. Befindet sich das zweite UHF-RFID-Etikett 10b außerhalb der Energiereichweite des ersten UHF-RFID-Senders 100a, jedoch innerhalb dessen Kommunikationsreichweite, kann durch zusätzlichen Energieeintrag des zweiten UHF-RFID-Senders 100b das zweite UHF-RFID-Etikett 100b mit ausreichend Energie beaufschlagt werden, um mit dem ersten UHF-RFID-Sender 100a zu kommunizieren. Aufgrund der zusätzlichen Energieversorgung des zweiten UHF-RFID-Etiketts 10b kann es Signale kleinerer Amplitude auswerten. Der Abstand zwischen dem ersten UHF-RFID-Sender 100a und zweiten UHF-RFID-Etikett 10b kann vergrößert werden (s. Strich-Doppelpunkt-Linie um ersten UHF-RFID-Sender 100a). Entsprechendes gilt für das vierte UHF-RFID-Etikett 10d in Verbindung unter Nutzung des vierten UHF-RFID-Senders 100d zur Kommunikation mit dem ersten UHF-RFID-Sender 100a.

Die Energiereichweite ist die Reichweite eines UHF-RFID-Senders, innerhalb dessen ein UHF-RFID-Etikett mit ausreichend Energie zu dessen Betrieb versorgt werden kann. Die Kommunikationsreichweite ist die Reichweite eines UHF-RFID-Etiketts, innerhalb der ein UHF-RFID-Etikett mit einem UHF-RFID-Sender kommunizieren könnte, sofern ausreichend Energie zum Betrieb des UHF-RFID-Etiketts das UHF-RFID-Etikett erhält. Die Energiereichweite ist in der Regel kleiner als die Kommunikationsreichweite.

Das elektromagnetische Fernfeld des zweiten UHF-RFID-Senders 100b erreicht das dritte UHF-RFID-Etikett 10c. Die Kommunikationsreichweite des ersten UHF-RFID-Senders 100a kann jedoch nicht ausreichend erhöht werden, damit das dritte UHF-RFID-Etikett 10c dem ersten UHF-RFID-Sender 100a antworten kann.

In Fig. 5a ist lediglich beispielhaft die Kommunikation ausgehend vom ersten UHF-RFID-Sender 100a dargestellt. Die Kommunikation kann entsprechend auf einen anderen UHF-RFID-Sender, bspw. den zweiten, dritten und/oder vierten UHF-RFID-Sender 100b, 100c, 100d übertragen werden. Grundsätzlich ist zu beachten, dass nur ein UHF-RFID-Sender ein gültiges Kommunikationssignal, d. h. ein moduliertes UHF-RFID-Signal, sendet. Andere Sender, bspw. zweiter, dritter und vierter UHF-RFID-Sender 100b, 100c, 100d, senden vorzugsweise ein unmoduliertes Signal. Aufgrund unmodulierter Signale wird dem UHF-RFID-Etikett lediglich zusätzliche Energie bereitgestellt. Mithilfe der Erfindung kann das UHF-RFID-Etikett aus den überlagerten Signalen einen Bitstrom entsprechend dem modulierten Signal generieren. Sollten zwei UHF-RFID-Sender gleichzeitig ein dem UHF-RFID-Etikett erkennbare modulierte Signale senden, könnte das UHF-RFID-Etikett aus der Überlagerung der beiden modulierten Signale keinen Bitstrom generieren.

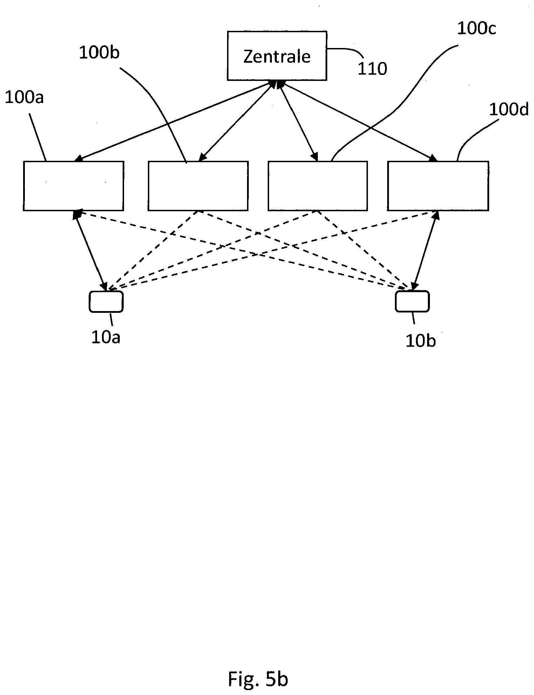

In Fig. 5b ist ein Ausführungsbeispiel einer Steuerung für die Reichweitenerhöhung gemäß Fig. 5a dargestellt. Eine Zentrale 110 steuert die UHF-RFID-Sender 100a, 100b, 100c, 100d. Die Zentrale 110 legt fest, welcher UHF-RFID-Sender 100a, 100b, 100c, 100d mit dem ersten und/ oder zweiten RFID-Etikett 10a, 10b (nur erstes und zweites RFID-Etikett 10a, 10b in Figur 4b dargestellt) kommunizieren darf. Insbesondere legt die Zentrale 110 fest, welcher UHF-RFID-Sender 100a, 100b, 100c, 100d ein für das erste und/ oder zweite RFID-Etikett 10a, 10b demodulierbares erstes Signal sendet und welcher der UHF-RFID-Sender 100a, 100b, 100c, 100d ein unmoduliertes bzw. ein für das erste und/ oder zweite UHF-RFID-Etikett nicht-demodulierbares Signal versenden. So sendet der erste UHF-RFID-Sender 100a ein für das erste RFID-Etikett 10a demodulierbares Signal, wogegen der zweite, dritte und vierte UHF-RFID-Sender 100b, 100c, 100d jeweils ein für das erste RFID-Etikett 10a unmoduliertes Signal sendet. Somit kann die Kommunikationsreichweite zwischen dem ersten UHF-RFID-Sender 100a und dem ersten RFID-Etikett 10a vergrößert werden. Analog sendet der vierte UHF-RFID-Sender 100d ein für das zweite RFID-Etikett 10b demodulierbares Signal, wogegen der erste, zweite und dritte UHF-RFID-Sender 100a, 100b, 100c jeweils ein für das zweite RFID-Etikett 10b unmoduliertes Signal sendet. Somit kann die Kommunikationsreichweite zwischen dem vierten UHF-RFID-Sender 100d und dem zweiten RFID-Etikett 10b vergrößert werden. Das System ist jedoch derart ausgestaltet, dass entweder der erste und vierte UHF-RFID-Sender 100a, 100d nicht gleichzeitig senden oder der erste und vierte UHF-RFID-Sender 100a, 100d jeweils ein Signal mit unterschiedlicher Modulationsart versenden.

Vorzugsweise weist die Zentrale 110 gezielt einen UHF-RFID-Sender 100a, 100b, 100c, 100d an. Alternativ können auch mehrere der ersten, zweiten, dritten und/ oder vierten UHF-RFID-Sender 100a, 100b, 100c, 100d zur Kommunikation mit dem ersten und/ oder zweiten UHF-RFID-Etikett 10a, 10b beauftragt werden, wobei der erste, zweite, dritte und/ oder vierte UHF-RFID-Sender 100a, 100b, 100c, 100d nicht gleichzeitig ein moduliertes Signal betreffend das erste und/ oder zweite UHF-RFID-Etikett 10a, 10b versenden.

Zusätzlich zur Kommunikation kann eine räumliche Lokalisierung der ersten und/ oder zweiten UHF-RFID-Etiketten 10a, 10b durch Auswertung der Signale bezüglich der Trägerfrequenzen vorgenommen werden. Außer der Steuerung der UHF-RFID-Sender kann die Zentrale 110 die Funktion einer zentralen Kommunikationsstelle, z. B. Verteilzentrum aller Nachrichten, übernehmen.

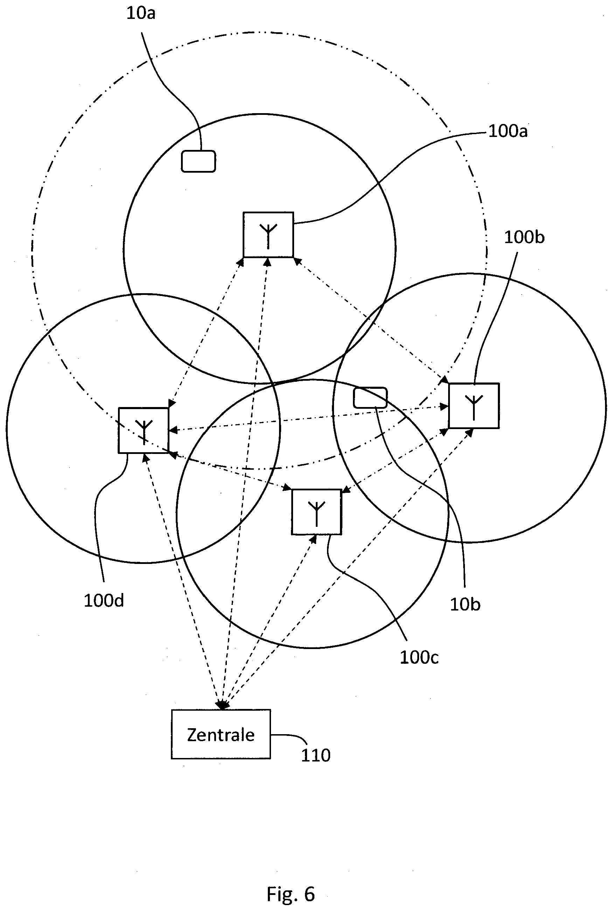

In der Figur 6 ist ein weiteres Anwendungsbeispiel der Erfindung dargestellt. Der räumliche Aufbau ist ähnlich der Figur 5a. Anstatt der Kommunikation zwischen einem UHF-RFID-Sender 100a, 100b, 100c, 100d und einem der UHF-RFID-Etiketten 10a, 10b, 10c, 10d wird in dieser Figur eine Kommunikation zwischen den UHF-RFID-Sender 100a, 100b, 100c, 100d untereinander betrachtet.

Zur Kommunikation zwischen UHF-RFID-Sender 100a, 100b, 100c, 100d und UHF-RFID-Etikett 10a, 10b, 10c sendet der erste UHF-RFID-Sender 100a ein moduliertes Signal. Der zweite, dritte und vierte UHF-RFID-Sender 100b, 100c, 100d senden ein unmoduliertes Signal. Anstatt unmoduliertem Signal können der zweite, dritte und vierte UHF-RFID-Sender 100b, 100c, 100d ein Signal senden, das vom ersten, zweiten und dritten UHF-RFID-Etikett 10a, 10b, 10c nicht demodulierbar ist. Somit erscheint ein derartiges Signal ebenfalls als Störsignal bzw. als unmoduliertes Signal für das erste, zweite und dritte UHF-RFID-Etikett 10a, 10b, 10c. Dass ein Signal nicht demodulierbar ist, bedingt nicht, dass es zu 100% auf der Trägerfrequenz unmoduliert ist. Vielmehr kann das Signal Daten aufweisen, die mit einem für das UHF-RFID-Etikett unbekannten Modulationsverfahren oder Codierverfahren auf einer Trägerfrequenz moduliert sind. Während beispielsweise Daten zwischen dem ersten, zweiten, dritten und vierten UHF-RFID-Sender 100a, 100b, 100c, 100d und dem ersten, zweiten und dritten UHF-RFID-Etikett 10a, 10b, 10c mittels ASK-Modulation übertragen werden, kann der erste, zweite, dritte und/ oder vierte UHF-RFID-Sender 100a, 100b, 100c, 100d ein Signal mit FSK-Modulation versenden. Dieses Signal wäre für das erste, zweite oder dritte UHF-RFID-Etikett 10a, 10b, 10c nicht demodulierbar. Der erste, zweite, dritte und/ oder vierte UHF-RFID-Sender könnte zum Demodulieren eines mit FSK-Modulation moduliertes Signal ausgebildet sein. Ein Datenaustausch (Strich-Punkt-Linie) zwischen den UHF-RFID-Sendern 100a, 100b, 100c, 100d unter Anwendung einer FSK-Modulation kann stattfinden. Daten mittels FSK-Modulation sind für die UHF-RFID-Etiketten 10a, 10b, 10c, 10d nicht demodulierbar. Somit kann sichergestellt werden, dass die Kommunikation zwischen den UHF-RFID-Sendern 100a, 100b, 100c, 100d nicht von den UHF-RFID-Etiketten 10a, 10b, 10c, 10d verarbeitet wird. Die UHF-RFID-Sender 100a, 100b, 100c, 100d können beispielsweise Steuersignale untereinander senden, beispielsweise für eine Stand-By-Funktion oder eine Änderung der Trägerfrequenz. Eine Zentrale 110 überwacht und steuert zusätzlich die UHF-RFID-Sender 100a, 100b, 100c, 100d (strichlierte Linie).

Aus der Beschreibung und den Figuren kann entnommen werden, dass die Erfindung zur verbesserten Störverträglichkeit eines UHF-RFID-Geräts beiträgt. Störsignale, die im gleichen Frequenzband wie das gewünschte Datensignal empfangen werden, können einfach, in kleiner Bauweise und kostengünstig herausgefiltert werden. Zudem kann durch die Erfindung die Reichweite von UHF-RFID-Tags erhöht werden. Weiterhin kann eine Kommunikation zwischen UHF-RFID-Sendern stattfinden.

## Patentansprüche

1. Verfahren zum Anpassen eines ersten Referenzwertes zum Generieren eines ersten Bitstroms (20) aus einem Eingangssignal (s) durch eine erste Amplitudenanpassungseinheit (12), wobei das Eingangssignal (s) ein erstes und ein zweites Signal (s1, s2) umfasst, das erste Signal (s1) und das zweite Signal (s2) ein Basisband-Summensignal bilden, ein erstes nichtlineares Bauteil (18) das Eingangssignal (s) demoduliert und ein demoduliertes Eingangssignal (21a) ausgibt und die Amplitudenanpassungseinheit (12) basierend auf einen ersten Referenzwert aus dem demoduliertem Eingangssignal (21a) den ersten Bitstrom (20) ausgibt,
**dadurch gekennzeichnet, dass**
eine Referenzwertanpassungseinheit (19) eine Detektionseinheit (191) umfasst, welche das erste und das zweite Signal (s1, s2) detektiert und bei Wegfall des ersten und zweiten Signals (s1, s2) eine Angleicheinheit (192) den ersten Referenzwert auf einen Grundreferenzwert angleicht.

2. Verfahren nach Anspruch 1, **dadurch gekennzeichnet, dass** das erste Signal (s1) eine erste Signalamplitude und das zweite Signal (s2) eine zweite Signalamplitude aufweist, die erste und zweite Signalamplituden eine Summenamplitude des Basisband-Summensignals (21b) bilden und der erste Referenzwert dem Verlauf der Summenamplitude folgt.

3. Verfahren nach einem der vorhergehenden Ansprüche, **dadurch gekennzeichnet, dass** die Angleicheinheit (192) mittels einer Schalteinheit (192) den ersten Referenzwert auf den Grundreferenzwert abgleicht.

4. Verfahren nach einem der vorhergehenden Ansprüche, **dadurch gekennzeichnet, dass** eine Konstantspannungsquelle (16) den Grundreferenzwert bereitstellt.

5. Verfahren nach einem der vorhergehenden Ansprüche, **dadurch gekennzeichnet, dass** der Detektionseinheit (191) zum Detektieren des zweiten Signals (s2) der Grundreferenzwert bereitgestellt wird.

6. Verfahren nach einem der Ansprüche 2 bis 5, **dadurch gekennzeichnet, dass** die Detektionseinheit (191) eine Spannungsdifferenz zwischen dem Grundreferenzwert und der Summenamplitude bestimmt.

7. Verfahren nach einem der vorhergehenden Ansprüche, **dadurch gekennzeichnet, dass** das erste Signal (s1) auf einer ersten Trägerfrequenz und das zweite Signal (s2) auf einer zweiten Trägerfrequenz moduliert ist, wobei das erste und zweite Signal (s1, s2) ein Mischsignal (21b) bilden und das Mischsignal (21b) das erste Signal (s1), das zweite Signal (s2) und ein Mischprodukt aus dem ersten Signal (s1) und dem zweiten Signal (s2) auf einer Zwischenfrequenz umfasst, wobei ein zweites nichtlineares Bauteil (144) das Mischprodukt demoduliert und eine zweite Amplitudenwertanpassungseinheit (142) aus dem demodulierten Mischprodukt einen zweiten Bitstrom (23) betreffend das erste Signal (s1) generiert.

8. Verfahren nach Anspruch 7, **dadurch gekennzeichnet, dass** der erste Bitstrom (20) am Ausgang der ersten Amplitudenwertanpassungseinheit (12) und/ oder der zweite Bitstrom (23) der zweiten Amplitudenwertanpassungseinheit (142) einer Ausgabelogik (13) zugeführt werden.

9. Verfahren nach einem der vorhergehenden Ansprüche, **dadurch gekennzeichnet, dass** die Detektionseinheit (191) eine Flanke des ersten und/ oder zweiten Signals (s1, s2) detektiert.

10. Schaltung zum Anpassen eines ersten Referenzwertes zum Generieren eines ersten Bitstromes (20) aus einem Eingangssignal (s), wobei das Eingangssignal (s) ein erstes Signal (s1) und ein zweites Signal (s2) umfasst, das erste Signal (s1) eine erste Signalamplitude und das zweite Signal (s2) eine zweite Signalamplitude aufweist, und die erste Signalamplitude mit der zweiten Signalamplitude eine Summenamplitude bilden, die Schaltung ein erstes nichtlineares Bauteil (18) und eine erste Amplitudenwertanpassungseinheit (12) aufweist, das erste nichtlineare Bauteil (18) ausgebildet ist, das Eingangssignal (s) zu demodulieren und ein demoduliertes Eingangssignal auszugeben und die erste Amplitudenwertanpassungseinheit (12) ausgebildet ist, aus dem demodulierten Eingangssignal (21a) basierend auf einen ersten Referenzwert den ersten Bitstrom (20) zu generieren,
**dadurch gekennzeichnet, dass**
die Schaltung eine Detektionseinheit (191) und eine Angleicheinheit (192) umfasst, wobei die Detektionseinheit (191) ausgebildet ist, festzustellen, ob im Eingangssignal (s) das erste Signal (s1) und das zweite Signal (s2) vorhanden ist, und die Angleicheinheit (192) ausgebildet ist, den ersten Referenzwert auf einen Grundreferenzwert anzupassen, wenn das erste Signal (s1) und das zweite Signal (s2) wegfällt.

11. Schaltung nach Anspruch 10, **dadurch gekennzeichnet, dass** die Schaltung in einem Sicherheitsmodul (10) eingesetzt wird.

12. Schaltung nach einem der Ansprüche 10 oder 11, **dadurch gekennzeichnet, dass** die Angleicheinheit (192) einen Schalter umfasst, wobei die Angleicheinheit (192) ausgebildet ist, ein Spannungsniveau des ersten Referenzwerts an das Spannungsniveau des Grundreferenzwerts zu koppeln.

13. Schaltung nach einem der Ansprüche 10 bis 12, **dadurch gekennzeichnet, dass** die Schaltung eine Konstantspannungsquelle (16) aufweist, wobei die Konstantspannungsquelle (16) ausgebildet ist, den Grundreferenzwert bereitzustellen.

14. Schaltung nach einem der Ansprüche 10 bis 13, **dadurch gekennzeichnet, dass** die Schaltung eine Ausgabelogik (13) aufweist, wobei ein erster Eingang der Ausgabelogik (13) mit dem ersten Bitstrom (20) gekoppelt ist und die Ausgabelogik (13) ausgebildet ist, einen Bitstrom des ersten Signals (s1) zu generieren.

15. Schaltung nach einem der Ansprüche 10 bis 14, **dadurch gekennzeichnet, dass** die Schaltung ein Frequenzfilter (141) ein zweites nichtlineares Bauteil (144) und eine zweite Amplitudenwertanpassungseinheit (142) umfasst, wobei das Frequenzfilter (141) dem ersten nichtlinearen Bauteil (18) nachgeschaltet ist, das erste nichtlineare Bauteil (18) ein Mischprodukt ausgibt und das Frequenzfilter (141) ein Mischprodukt des ersten und zweiten Signals (s1, s2) auf einer Zwischenfrequenz ausgibt und das zweite nichtlineare Bauteil (144) das Mischprodukt demoduliert und die zweite Amplitudenwertanpassungseinheit (142) ausgebildet ist, einen zweiten Bitstrom (23) zu generieren und ein zweiter Eingang der Ausgabelogik (13) mit dem zweiten Bitstrom (23) gekoppelt ist.

## Claims

1. A method for adapting a first reference value for generating a first bit stream (20) from an input signal (s) by a first amplitude adapting unit (12), wherein the input signal (s) comprises a first and a second signal (s1, s2), the first signal (s1) and the second signal (s2) form a baseband sum signal, a first non-linear component (18) demodulates the input signal (s) and outputs a demodulated input signal (21a), and the amplitude adapting unit (12) outputs the first bit stream (20) from the demodulated input signal (21a) on the basis of a first reference value,
**characterized in that**
a reference-value adapting unit (19) comprises a detection unit (191), which detects the first and the second signal (s1, s2), and upon discontinuation of the first and the second signal (s1, s2) an adjusting unit (192) adjusts the first reference value to a basic reference value.

2. The method according to claim 1, **characterized in that** the first signal (s1) has a first signal amplitude and the second signal (s2) a second signal amplitude, the first and second signal amplitudes form a sum amplitude of the baseband sum signal (21b), and the first reference value follows the course of the sum amplitude.

3. The method according to any of the preceding claims, **characterized in that** the adjusting unit (192) matches the first reference value to the basic reference value by means of a switch unit (192).

4. The method according to any of the preceding claims, **characterized in that** a constant-voltage source (16) supplies the basic reference value.

5. The method according to any of the preceding claims, **characterized in that** the basic reference value is supplied to the detection unit (191) for detecting the second signal (s2).

6. The method according to any of claims 2 to 5, **characterized in that** the detection unit (191) determines a voltage difference between the basic reference value and the sum amplitude.

7. The method according to any of the preceding claims, **characterized in that** the first signal (s1) is modulated on a first carrier frequency and the second signal (s2) on a second carrier frequency, wherein the first and second signal (s1, s2) form a mixed signal (21b) and the mixed signal (21b) comprises the first signal (s1), the second signal (s2) and a mixed product of the first signal (s1) and the second signal (s2) on an intermediate frequency, wherein a second non-linear component (144) demodulates the mixed product and a second amplitude value adapting unit (142) generates from the demodulated mixed product a second bit stream (23) relating to the first signal (s1).

8. The method according to claim 7, **characterized in that** the first bit stream (20) at the output of the first amplitude value adapting unit (12) and/or the second bit stream (23) of the second amplitude value adapting unit (142) are fed to an output logic (13).

9. The method according to any of the preceding claims, **characterized in that** the detection unit (191) detects an edge of the first and/or second signal (s1, s2).

10. A circuit for adapting a first reference value for generating a first bit stream (20) from an input signal (s), wherein the input signal (s) comprises a first signal (s1) and a second signal (s2), the first signal (s1) has a first signal amplitude and the second signal (s2) a second signal amplitude, and the first signal amplitude forms a sum amplitude with the second signal amplitude, the circuit comprises a first non-linear component (18) and a first amplitude value adapting unit (12), the first non-linear component (18) is configured to demodulate the input signal (s) and to output a demodulated input signal, and the first amplitude value adapting unit (12) is configured to generate the first bit stream (20) from the demodulated input signal (21a) on the basis of a first reference value,
**characterized in that**
the circuit comprises a detection unit (191) and an adjusting unit (192), wherein the detection unit (191) is configured to ascertain whether the first signal (s1) and the second signal (s2) are present in the input signal (s), and the adjusting unit (192) is configured to adapt the first reference value to a basic reference value if the first signal (s1) and the second signal (s2) are discontinued.

11. The circuit according to claim 10, **characterized in that** the circuit is used in a security module (10).

12. The circuit according to either of claims 10 or 11, **characterized in that** the adjusting unit (192) comprises a switch, wherein the adjusting unit (192) is configured to couple a voltage level of the first reference value to the voltage level of the basic reference value.

13. The circuit according to any of claims 10 to 12, **characterized in that** the circuit has a constant-voltage source (16), wherein the constant-voltage source (16) is configured to supply the basic reference value.

14. The circuit according to any of claims 10 to 13, **characterized in that** the circuit has an output logic (13), wherein a first input of the output logic (13) is coupled with the first bit stream (20) and the output logic (13) is configured to generate a bit stream of the first signal (s1).

15. The circuit according to any of claims 10 to 14, **characterized in that** the circuit comprises a frequency filter (141), a second non-linear component (144) and a second amplitude value adapting unit (142), wherein the frequency filter (141) is connected downstream of the first non-linear component (18), the first non-linear component (18) outputs a mixed product and the frequency filter (141) outputs a mixed product of the first and second signal (s1, s2), on an intermediate frequency, and the second non-linear component (144) demodulates the mixed product, and the second amplitude value adapting unit (142) is configured to generate a second bit stream (23), and a second input of the output logic (13) is coupled with the second bit stream (23).

## Revendications

1. Procédé d'adaptation d'une première valeur de référence aux fins de la génération d'un premier flux de bits (20) à partir d'un signal d'entrée (s) par une première unité d'adaptation d'amplitude (12), cependant que le signal d'entrée (s) comprend un premier et un deuxième signal (s1, s2), que le premier signal (s1) et le deuxième signal (s2) constituent un signal somme de bande de base, qu'un premier composant non linéaire (18) démodule le signal d'entrée (s) et délivre un signal d'entrée démodulé (21a), et que l'unité d'adaptation d'amplitude (12) délivre, sur la base d'une première valeur de référence, le premier flux de bits (20) à partir du signal d'entrée démodulé (21a)
**caractérisé en ce que**
une unité d'adaptation de valeur de référence (19) comprend une unité de détection (191) qui détecte le premier et le second signal (s1, s2) et que, en cas de disparition du premier et du deuxième signal (s1, s2), une unité d'alignement (192) aligne la première valeur de référence sur une valeur de référence de base.

2. Procédé selon la revendication 1, **caractérisé en ce que** le premier signal (s1) présente une première amplitude de signal et que le deuxième signal (s2) présente une deuxième amplitude de signal, que la première et la deuxième amplitude de signal constituent une amplitude somme du signal somme de bande de base (21b), et que la première valeur de référence suit la courbe de l'amplitude somme.

3. Procédé selon une des revendications précédentes, **caractérisé en ce que** l'unité d'alignement (192) ajuste au moyen d'une unité de commutation (192) la première valeur de référence sur la valeur de référence de base.

4. Procédé selon une des revendications précédentes, **caractérisé en ce qu'**une source de tension constante (16) met à disposition la valeur de référence de base.

5. Procédé selon une des revendications précédentes, **caractérisé en ce que**, pour la détection du deuxième signal (s2), la valeur de référence de base est mise à la disposition de l'unité de détection (191).

6. Procédé selon une des revendications de 2 à 5, **caractérisé en ce que** l'unité de détection (191) détermine une différence de tension entre la valeur de référence de base et l'amplitude somme.

7. Procédé selon une des revendications précédentes, **caractérisé en ce que** le premier signal (s1) est modulé sur une première fréquence porteuse et que le deuxième signal (s2) est modulé sur une deuxième fréquence porteuse, cependant que le premier et le deuxième signal (s1, s2) constituent un signal mixte (21b) et que le signal mixte (21b) comprend le premier signal (s1), le deuxième signal (s2) et un produit mixte du premier signal (s1) et du deuxième signal (s2) sur une fréquence intermédiaire, cependant qu'un deuxième composant non linéaire (144) démodule le
produit mixte et qu'une deuxième unité d'adaptation de valeur d'amplitude (142) génère, à partir du produit mixte démodulé, un deuxième flux de bits (23) concernant le premier signal (s1).

8. Procédé selon la revendication 7, **caractérisé en ce que** le premier flux de bits (20) à la sortie de la première unité d'adaptation de valeur d'amplitude (12) et/ou le deuxième flux de bits (23) de la deuxième unité d'adaptation de valeur d'amplitude (142) sont amenés à une logique de sortie (13).

9. Procédé selon une des revendications précédentes, **caractérisé en ce que** l'unité de détection (191) détecte un flanc du premier et/ou du deuxième signal d'entrée (s1, s2).

10. Circuit d'adaptation d'une première valeur de référence aux fins de la génération d'un premier flux de bits (20) partir d'un signal d'entrée (s), cependant que le signal d'entrée (s) comprend un premier signal (s1) et un deuxième signal (s1), que le premier signal (s1) présente une première amplitude de signal et que le deuxième signal (s2) présente une deuxième amplitude de signal, et que la première amplitude de signal constitue avec la deuxième amplitude de signal une amplitude somme, que le circuit comporte un premier composant non linéaire (18) et une première unité d'adaptation de valeur d'amplitude (12), que le premier composant non linéaire (18) est conçu pour démoduler le signal d'entrée (s) et délivrer un signal d'entrée démodulé, et que la première unité d'adaptation d'amplitude (12) est conçue pour générer, à partir du signal d'entrée démodulé (21a), sur la base d'une première référence, le premier flux de bits (20),
**caractérisé en ce que**
le circuit comprend une unité de détection (191) et une unité d'alignement (192), cependant que l'unité de détection (191) est conçue pour constater si, dans le signal d'entrée (s), il y a le premier signal (s1) et le deuxième signal (s2), et que l'unité d'alignement (192) est conçue pour adapter la première valeur de référence à une valeur de référence de base quand le premier signal (s1) et le deuxième signal (s2) disparaît.

11. Circuit selon la revendication 10, **caractérisé en ce que** le circuit est utilisé dans un module de sécurité (10).

12. Circuit selon une des revendications 10 ou 11, **caractérisé en ce que** l'unité d'alignement (192) comprend un commutateur, cependant que l'unité d'alignement (192) est conçue pour coupler un niveau de tension de la première valeur de référence u niveau de tension de la valeur de référence de base.

13. Circuit selon une des revendications de 10 à 12, **caractérisé en ce que** le circuit comporte une source de tension constante (16), cependant que la source de tension constante (16) est conçue pour mettre à disposition la valeur de référence de base.

14. Circuit selon une des revendications de 10 à 13, **caractérisé en ce que** le circuit comporte une logique de sortie (13), cependant qu'une première entrée de la logique de sortie (13) est couplée avec le premier flux de bits (20) et que la logique de sortie (13) est conçue pour générer un flux de bits du premier signal (s1).

15. Circuit selon une des revendications de 10 à 14, **caractérisé en ce que** le circuit comprend un filtre de fréquences (141), un deuxième composant non linéaire (144) et une deuxième unité d'adaptation de valeur d'amplitude (142), cependant que le filtre de fréquences (141) est monté en aval du premier composant non linéaire (18), que le premier composant non linéaire (18) délivre un produit mixte et que le filtre de fréquences (141) délivre un produit mixte du premier et du deuxième signal (s1, s2) sur une fréquence intermédiaire, et que le deuxième composant non linéaire (144) démodule le produit mixte et que la deuxième unité d'adaptation de valeur d'amplitude (142) est conçue pour générer un deuxième flux de bits (23), et qu'une deuxième entrée de la logique de sortie (13) est couplée avec le deuxième flux de bits (23).
